# EUROPEAN PATENT APPLICATION

(11) **EP 4 629 281 A1**
(43) Date of publication of application: **08.10.2025**
(21) Application number: 23897166.7
(22) Date of filing: 29.08.2023
(51) Int. Cl.: H01L 21/205, C30B 29/04, C30B 29/38

(54) **METHOD FOR PRODUCING HETEROEPITAXIAL SUBSTRATE**

(30) Priority: 29.11.2022 JP 2022190167
(71) Applicant: Shin-Etsu Handotai Co., Ltd., Tokyo 100-0004 (JP)
(72) Inventor: OHTSUKI, Tsuyoshi, Nishishirakawa-gun, Fukushima 961-8061 (JP); ABE, Tatsuo, Nishishirakawa-gun, Fukushima 961-8061 (JP); SATO, Michito, Nishishirakawa-gun, Fukushima 961-8061 (JP); MIZUSAWA, Yasushi, Annaka-shi, Gunma 379-0196 (JP); MATSUBARA, Toshiki, Nishishirakawa-gun, Fukushima 961-8061 (JP); SUZUKI, Atsushi, Nishishirakawa-gun, Fukushima 961-8061 (JP)
(74) Representative: Röthinger, Rainer
(86) International application number: PCT/JP2023/031184
(87) International publication number: WO 2024/116506

(57) **Abstract**

The present invention is a method for producing a heteroepitaxial substrate, the method including the steps of producing a substrate in which a silicon single crystal substrate is produced under thickness conditions of a thickness of 2 mm or less, the thickness exceeds an upper limit of a thickness standard defined corresponding to a diameter of the silicon single crystal substrate, epitaxially growing a heteroepitaxial layer on the silicon single crystal substrate obtained in the step of producing the substrate to obtain an epitaxial substrate, and thinning the silicon single crystal substrate so as to fall within the thickness standard by grinding a surface of the silicon single crystal substrate opposite to a surface on which the heteroepitaxial layer is formed after the step of epitaxially growing. This provides the method for producing a heteroepitaxial substrate that can be introduced in an existing device process, even when the thickness of the silicon single crystal substrate is thicker than the standard to form the heteroepitaxial layer.

## Description

### TECHNICAL FIELD

The present invention relates to a method for producing a heteroepitaxial substrate.

### BACKGROUND ART

A technique of forming various heteroepitaxial layers, including diamond, on a silicon single crystal substrate is an extremely effective method as expensive materials are grown on inexpensive silicon materials, and thus enables inexpensive and large-diameter growth. However, since materials different from silicon are grown, stress is generated in a substrate after an epitaxial growth due to differences from silicon in lattice constant and coefficient of linear expansion. This causes a problem of warp of the substrate due to stress, or in the worst cases, cracks are generated in the substrate, resulting in damage.

Accordingly, methods of adjusting contents of light metals in substrates to ensure strength of silicon (Patent Documents 1 to 3) have been proposed, and in addition to methods of adjusting the contents, a method of controlling (normally thickening) a thickness of a silicon single crystal substrate itself has been proposed. For example, Patent Document 4 discloses that when a diamond layer is formed on a silicon single crystal substrate to produce a bonded substrate, a lower limit of the thickness of a silicon support substrate is preferably 0.05 mm or more, more preferably 0.2 mm or more, and the upper limit of the thickness is 5 mm or less.

Furthermore, Patent Document 5 proposes a silicon single crystal substrate having a thickness of 0.3 to 2 mm; Patent Document 6 proposes a substrate for growing a single crystal diamond in which a silicon single crystal substrate has a thickness of at least 0.03 mm to 20.00 mm; Patent Document 7 proposes a base substrate made of single crystal silicon (Si) having a thickness of 0.03 mm or more and 20.00 mm or less; Patent Document 8 proposes a diamond-forming structure for forming a single-crystal diamond and a method for producing such a structure, in which a thickness of a base substrate is about 0.01 to 15 mm; and Patent Document 9 proposes a silicon substrate for growing a free-standing diamond film to have a thickness of 4 mm or more or 2 mm or more.

### CITATION LIST

### PATENT LITERATURE

Patent Document 1: JP 2020-102598 A
Patent Document 2: JP 2022-124012 A
Patent Document **3:** JP 2002-261011 A
Patent Document 4: WO 2019/039533 A1
Patent Document 5: JP 2009-238971 A
Patent Document 6: JP 2011-079683 A
Patent Document 7: JP 2012-001394 A
Patent Document 8: JP 2022-068862 A
Patent Document 9: WO 2016/168796 A1

### SUMMARY OF INVENTION

### TECHNICAL PROBLEM

In this way, while a proposal to suppress warping and cracking is provided by focusing on a thickness of a silicon single crystal substrate and thickening thereof when performing heteroepitaxial growth on the silicon single crystal substrate, the thickness of the substrate differs from the thicknesses for each diameter standardized according to SEMI Standards for silicon devices when the thickness of the silicon single crystal substrate is made thicker than a conventional substrate as shown above. The substrate having a different thickness from such a standardized thickness is unable to be introduced into an existing device process, and on the assumption that a heteroepitaxial layer can be formed thereon, problems arise in subsequent steps such as using various materials, including diamond, in the devices or bonding processing, where it cannot be introduced due to difference in thickness, and this causes considerable problem for using as a semiconductor device. This is because when an epitaxial substrate is introduced into a production apparatus, etc., for the semiconductor device used in the subsequent step after the heteroepitaxial growth, the production apparatus also has a structure in which only epitaxial substrate having a dimension specified by the SEMI Standards can be introduced. Note that although it is theoretically possible to provide dedicated steps for the substrate having a thick film composed of diamond and various materials, it is not realistic to provide the apparatus for various steps just to process the substrates having the thick film due to significant cost increase.

The present invention has been made to solve the above-described problem. An object of the present invention is to provide a method for producing a heteroepitaxial substrate that can be introduced in the existing device process, even when the thickness of the silicon single crystal substrate is thicker than the standard to form the heteroepitaxial layer.

### SOLUTION TO PROBLEM

The present invention is a technique related to a silicon single crystal substrate used for heteroepitaxial growth, including diamond growth, on the silicon single crystal substrate. In more detail, it is the technique that optimizes a thickness of the silicon single crystal substrate to suppress cracking of a wafer during heteroepitaxial growth, and also enables a heteroepitaxial substrate after a growth of a heteroepitaxial layer to be introduced into an existing device process.

Specifically, the present invention has been made to achieve the above-described object and provides a method for producing a heteroepitaxial substrate, the method comprising the steps of:
producing a substrate in which a silicon single crystal substrate is produced under thickness conditions of a thickness of 2 mm or less, the thickness exceeds an upper limit of a thickness standard defined corresponding to a diameter of the silicon single crystal substrate;
epitaxially growing a heteroepitaxial layer on the silicon single crystal substrate obtained in the step of producing the substrate to obtain an epitaxial substrate; and
thinning the silicon single crystal substrate so as to fall within the thickness standard by grinding a surface of the silicon single crystal substrate opposite to a surface on which the heteroepitaxial layer is formed after the step of epitaxially growing.

In this method, a thick substrate exceeding the upper limit of thickness standard, i.e., the silicon single crystal substrate having a higher rigidity than a substrate within the thickness standard is provided as the silicon single crystal substrate for the heteroepitaxial growth, including diamond, on the silicon single crystal substrate. Accordingly, the heteroepitaxial layer made of heteroepitaxial materials, including diamond, is grown using this substrate to suppress warping and cracking. In addition, after growing the heteroepitaxial layer, by subjecting the surface of the silicon single crystal substrate, opposite to the surface on which the heteroepitaxial layer is formed, to a process represented by grinding or polishing, etc.; the silicon single crystal substrate is thinned to the thickness standard set for each diameter and this enables the substrate to be introduced into the existing device process.

Therefore, it is possible to produce the heteroepitaxial substrate, including diamond, which is adapted to an existing silicon process while suppressing warping and cracking. Even when the thickness of the silicon single crystal substrate is made thicker beyond the standard to form the heteroepitaxial layer, it is possible to introduce that substrate into the existing device process.

The step of epitaxially growing may be a step of growing the heteroepitaxial layer composed of any one of GaN, AlN, and diamond.

By using GaN for a material composing the heteroepitaxial layer, when a semiconductor device is formed, the device has a higher dielectric breakdown voltage and a faster electron saturation velocity than a silicon semiconductor device. By using AlN or diamond for a material composing the heteroepitaxial layer, when a semiconductor device is formed, the device has a significantly higher dielectric breakdown voltage than the silicon semiconductor device.

Prior to the step of producing the substrate,
a relation between a thickness of the silicon single crystal substrate and a thickness of the heteroepitaxial layer is determined in advance, where the heteroepitaxial layer prevents the epitaxial substrate from cracking after the step of epitaxially growing; and based on the relation, the step of determining the thickness may be performed to determine the thickness of the silicon single crystal substrate to be produced in the step of producing the substrate and the thickness of the heteroepitaxial layer to be grown in the step of epitaxially growing.

In this configuration, the thickness of the silicon single crystal substrate and the thickness of the heteroepitaxial layer are determined in advance, based on the relation between the thickness of the silicon single crystal substrate and the thickness of the heteroepitaxial layer in which the epitaxial substrate can be grown without cracking; consequently, the thicknesses of the silicon single crystal substrate and the heteroepitaxial layer can be made to be the necessary and sufficient thicknesses to prevent the epitaxial substrate from cracking.

### ADVANTAGEOUS EFFECTS OF INVENTION

According to the configuration of the present invention, even when the heteroepitaxial layer is grown on the silicon single crystal substrate having a large diameter, the heteroepitaxial growth can be performed without cracking in the epitaxial substrate, and the substrate is adaptable to the production process for the semiconductor device of the existing standard.

More specifically, even when the heteroepitaxial layer is formed by making the thickness of the silicon single crystal substrate thicker than the standard, such a substrate can subsequently be introduced into the existing device process.

### BRIEF DESCRIPTION OF DRAWINGS

FIG. 1 is a schematic view illustrating an epitaxial substrate produced by a method for producing a heteroepitaxial substrate according to the present invention.
FIG. 2 is a schematic overview of a flowchart illustrating a method for producing a heteroepitaxial substrate according to the present invention.

### DESCRIPTION OF EMBODIMENTS

As described above, a method for producing a heteroepitaxial substrate is desired, in which the substrate can be introduced into an existing device process even when a thickness of a silicon single crystal substrate is thickened beyond a thickness standard to form a heteroepitaxial layer.

To solve the above problem, the present inventors have earnestly studied and found out that a method for producing a heteroepitaxial substrate, the method comprising the steps of:
producing a substrate in which a silicon single crystal substrate is produced under thickness conditions of a thickness of 2 mm or less, the thickness exceeds an upper limit of a thickness standard defined corresponding to a diameter of the silicon single crystal substrate;
epitaxially growing a heteroepitaxial layer on the silicon single crystal substrate obtained in the step of producing the substrate to obtain an epitaxial substrate; and
thinning the silicon single crystal substrate so as to fall within the thickness standard by grinding a surface of the silicon single crystal substrate opposite to a surface on which the heteroepitaxial layer is formed after the step of epitaxially growing. Accordingly, it is also found that even when the thickness of the silicon single crystal substrate is thickened beyond the standard to form the heteroepitaxial layer, that substrate can be introduced into the existing device process. Based on the findings, the present invention has been completed.

Hereinafter, an embodiment of the present invention will be described with reference to the drawings. However, the present invention is not limited thereto.

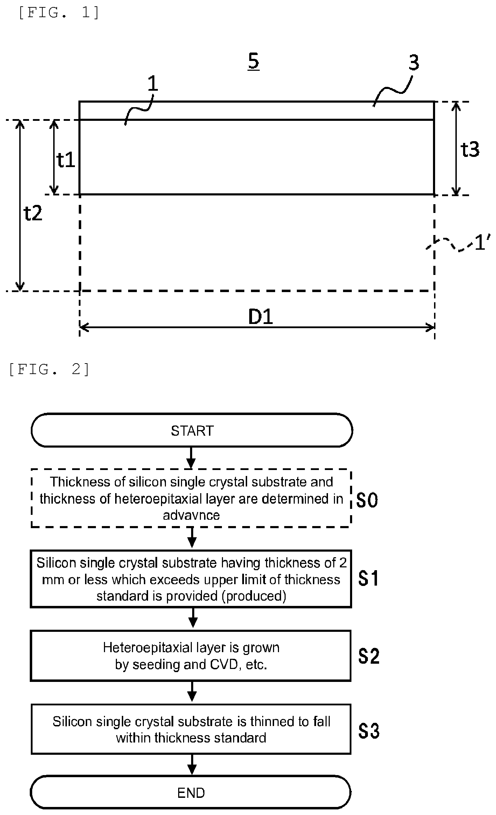

First, a configuration of an epitaxial substrate 5 produced by a method for producing a heteroepitaxial substrate according to the embodiment of the present invention will be simply described with reference to FIG. 1.

As shown in FIG. 1, an epitaxial substrate 5, being a heteroepitaxial substrate, is provided with a silicon single crystal substrate 1 and a heteroepitaxial layer 3 formed on one surface of the silicon single crystal substrate 1.

The silicon single crystal substrate 1 is a silicon single crystal that serves as a support substrate when the heteroepitaxial layer 3 is grown, and dimensions and a shape thereof can be selected as appropriate according to a material, dimensions, and a shape of the heteroepitaxial layer 3 to be grown, but a disc-shaped wafer, as referred to, can be exemplified.

A thickness "t1" of this wafer, corresponding to a diameter D1 (also referred to as wafer size) in FIG. 1, is specified in standards such as SEMI Standards M1. Consequently, a production apparatus, etc. for a semiconductor device, used in the subsequent step after formation of the heteroepitaxial layer 3, is also configured to only be introduced with the epitaxial substrate 5 having the dimensions specified in the SEMI Standards.

The diameters specified in the SEMI Standards and specified thickness standards corresponding to the diameters are shown in Table 1 below, for example.

**[Table 1]**

| Wafer dimensions | 4 inches (100 mm) | 5 inches (125 mm) | 6 inches (150 mm) | 8 inches (200 mm) | 12 inches (300 mm) |
|---|---|---|---|---|---|
| Diameter (mm) | 100 ± 0.5 | 125 ± 0.5 | 150 ± 0.2 | 200 ± 0.2 | 300 ± 0.2 |
| Thickness (µm) | 520 ± 20 | 625 ± 20 | 675 ± 20 | 725 ± 20 | 775 ± 20 |

The heteroepitaxial layer 3 is a layer where the semiconductor device is formed and is composed of a heteroepitaxial material, i.e., material different from silicon.

The above is a brief description for a configuration of the epitaxial substrate 5.

Next, the method for producing a heteroepitaxial substrate according to the embodiment of the present invention is described with reference to FIGs. 1 and 2.

First, a silicon single crystal substrate 1' is produced under thickness conditions of a thickness of 2 mm or less, the thickness exceeds the upper limit of the thickness standard defined corresponding to the diameter of the substrate (S1 in FIG. 2, step of producing substrate). Note that in order to produce the silicon single crystal substrate 1' that satisfies such thickness conditions, it is sufficient to cut out thickly when slicing a silicon single crystal ingot to cut out the silicon single crystal substrate 1'.

This thickness condition is described as a thickness "t2" in FIG. 1.

By setting the thickness conditions that exceed the upper limit of the thickness standard, rigidity of the silicon single crystal substrate 1' is greater than a case where the thickness "t2" of the silicon single crystal substrate 1' is the thickness "t1" that is within the thickness standard range. Such rigidity allows for the suppression of warping and cracking when growing the heteroepitaxial layer 3. This point is specifically described.

For example, when the material of the heteroepitaxial layer 3 is diamond, stress is generated in the epitaxial substrate 5 after epitaxial growth due to differences in lattice constant and coefficient of linear expansion between diamond and silicon single crystal as shown in Table 2. This may cause warping; in the worst cases, cracks are generated.

**[Table 2]**

| | Diamond | Silicon |
|---|---|---|
| Lattice Constant (×10⁻¹⁰ m) | 3.56 | 5.43 |
| Coefficient of Linear Expansion (×10⁻⁶/K, 20°C) | 1.0 | 2.6 |

In addition, warping and cracking also adversely affect the epitaxial substrate during epitaxial growth of diamond using CVD, etc. For example, due to warping of the epitaxial substrate 5 during the epitaxial growth, the temperature distribution of the epitaxial substrate 5 being grown may change, easily resulting in poor uniformity of thickness, etc. Moreover, it is undesirable to introduce the substrate that has a high possibility of cracking in a reactor and to perform epitaxial growth processing, considering reactor management.

Accordingly, by setting the thickness conditions to the thickness "t2" that exceeds the upper limit of the thickness standard, the rigidity of the silicon single crystal substrate 1' is greater compared to when the thickness of the silicon single crystal substrate 1' is the thickness "t1" that is within the thickness standard range. This allows for the suppression of warping and cracking in the epitaxial substrate 5 after the growth and thickness non-uniformity during the epitaxial growth. Moreover, by suppressing warping and cracking of the epitaxial substrate 5, the reactor management also becomes easier.

Note that the thickness "t2" of the silicon single crystal substrate 1' can be thinner than the thickness that exceeds the upper limit of the thickness standard as long as the epitaxial substrate 5 is not cracked after the step of epitaxially growing; however, when the flatness and rigidity of the silicon single crystal substrate 1' are considered, it is preferable that thickness "t2" exceeds the upper limit of the thickness standard.

A reason to specify the thickness condition to 2 mm or less is as follows. The present invention suppresses warping and cracking when the heteroepitaxial layer 3 is grown by increasing the thickness of the silicon single crystal substrate 1' to the thickness greater than the upper limit of the thickness standard to increase rigidity. Accordingly, when considering only the suppression of warping and cracking during growth, it is preferable that the thickness **"t2"** of the silicon single crystal substrate 1' be as great as possible. However, it can be easily imagined that the upper limit of the thickness "t2" has a limitation when considering the increase of labor and cost required for processing to achieve the flatness of the silicon single crystal substrate 1' within a desired range, edge processing, and subsequent thinning, etc., as the thickness "t2" become thicker.

Specifically, when the silicon single crystal substrate 1' having a diameter of 300 mm is exemplified, the upper limit of the thickness "t2" is limited to 2 mm when a groove width of a storage BOX and a clearance of the apparatus are considered. This upper limit of 2 mm is the same for wafers of other diameters other than 300 mm in diameter. In the era of small diameters, when the diameter of the producible silicon single crystal substrate 1' was smaller than that in the present, the wafer thickness was indeed thinner than in the case of the diameter of 300 mm due in part to a precision of the apparatus. However, the clearance of 2 mm was still secured in the storage BOX apparatus.

Accordingly, it is desirable that the thickness "t2" has the thickness condition of 2 mm or less.

Next, the heteroepitaxial layer 3 is grown on the silicon single crystal substrate 1' obtained in the step of producing the substrate to obtain the epitaxial substrate 5 (S2 in FIG. 2, step of epitaxially growing).

In the step of epitaxially growing, the heteroepitaxial layer 3 is formed using a material different from silicon, which can form a desired device.

For example, the step of epitaxially growing is a step of growing the heteroepitaxial layer 3 composed of any one of GaN, AlN, and diamond.

By growing GaN as the heteroepitaxial layer 3, when the semiconductor device is formed on the heteroepitaxial layer 3, the device has a higher dielectric breakdown voltage and a faster electron saturation velocity than a silicon semiconductor device. By growing AlN or diamond as the heteroepitaxial layer 3, when the semiconductor device is formed on the heteroepitaxial layer 3, the device has an extremely higher dielectric breakdown voltage than the silicon semiconductor device.

Note that regarding a method for growing the heteroepitaxial layer 3, the method has no particular standard, and any method may be used as long as a desired heteroepitaxial layer 3 can be formed. For example, it is sufficient to use a known growth method, such as CVD. In FIG. 2, a case is described as an example in which a process referred to as seeding (Seeding) to implant seed particles such as diamond onto the substrate is performed, and the heteroepitaxial layer 3 made of diamond is then grown by CVD. Alternatively, the heteroepitaxial layer 3 may be grown by CVD after performing a process referred to as a scratching treatment, in which the substrate surface is roughened and damage is introduced thereon to serve as nuclei for growth.

Moreover, the layer thickness of the heteroepitaxial layer 3 can be adjusted by a growth temperature and a growth time, as the layer thickness is thickened with, for example, higher growth temperature or longer growth time. The upper limit of the layer thickness is a thickness at which the epitaxial substrate 5 is not warped or cracked due to the stress caused by the difference in the lattice constant or the coefficient of linear expansion between the silicon single crystal substrate 1' and the heteroepitaxial layer 3. It is sufficient that the lower limit of the layer thickness is a thickness at which the heteroepitaxial layer 3 can maintain the shape thereof as a layer, can be used for forming the device, and cannot be eliminated during the associated etching or polishing, etc.

When the step of epitaxially growing is completed, the silicon single crystal substrate 1' is thinned so as to fall within the thickness standard by grinding a surface (back surface) of the silicon single crystal substrate 1' opposite to a surface on which the heteroepitaxial layer 3 is formed after the step of epitaxially growing to produce the silicon single crystal substrate 1 (S3 in FIG. 2, step of thinning).

Since the thickness "t2" of the silicon single crystal substrate 1' of the epitaxial substrate 5 after the step of epitaxially growing exceeds the upper limit of the thickness standard, this substrate cannot be introduced into the semiconductor process in the present state. Consequently, even when the thickness of the silicon single crystal substrate 1' is made thicker than the standard and the heteroepitaxial layer 3 is then formed, the thickness of the epitaxial substrate 5 after the step of thinning falls within the thickness standard by thinning the silicon single crystal substrate 1' within the range of the thickness standard determined for each diameter in the step of thinning. Therefore, the epitaxial substrate 5 can be introduced into the existing device process, such as the semiconductor process.

The thickness "t1" of the silicon single crystal substrate 1 after the step of thinning shown in FIG. 1 is within the thickness standard, such as the SEMI Standards. When considering the flatness of the silicon single crystal substrate 1, etc., it is advantageous to set the lower limit of the above thickness to the lower limit of the thickness standard corresponding to each diameter currently used.

Moreover, in order to enable the introduction into the existing device process, the upper limit of the thickness "t1" of the silicon single crystal substrate 1 after the step of thinning is less than the upper limit of the thickness standard of the SEMI Standards.

The method of thinning includes various methods, such as grinding, polishing, and separating by H⁺ ion implanting, but is not limited thereto. In the silicon single crystal substrate 1, quality such as glossiness on the surface opposite to the surface on which the heteroepitaxial layer 3 is formed can be optimized through each process. Moreover, the thickness of the epitaxial substrate 5 after thinning may be defined by the thickness "t3", which includes the heteroepitaxial layer 3 grown on the surface, or may be defined by the thickness "t1" of the silicon single crystal substrate 1. These definitions can be optimized depending on each process. In the description below, unless otherwise specified, a case is described as an example in which the thickness of the silicon single crystal substrate 1 in the epitaxial substrate 5 after thinning is defined as "t1".

Note that the thickness of the silicon single crystal substrate 1' produced in the step of producing the substrate and the thickness of the heteroepitaxial layer 3 where the epitaxial substrate 5 is not cracked after the step of epitaxially growing have a relation. Specifically, the thicker the thickness of the silicon single crystal substrate 1', the thicker the thickness of the heteroepitaxial layer 3 where the epitaxial substrate 5 is not cracked after the step of epitaxially growing.

Therefore, it is preferable that, prior to the step of producing the substrate, a relation between the thickness of the silicon single crystal substrate 1' and the thickness of the heteroepitaxial layer 3 is determined in advance, where the heteroepitaxial layer 3 prevents the epitaxial substrate 5 from cracking after the step of epitaxially growing; and based on the relation, the thickness of the silicon single crystal substrate 1' to be produced in the step of producing the substrate and the thickness of the heteroepitaxial layer 3 to be grown in the step of epitaxially growing are determined (S0 in FIG. 2, step of determining the thickness).

In this configuration, the thickness of the silicon single crystal substrate 1' and the thickness of the heteroepitaxial layer 3 are determined in advance, based on the relation between the thickness of the silicon single crystal substrate 1' and the thickness of the heteroepitaxial layer 3, where the heteroepitaxial layer 3 prevents the epitaxial substrate 5 from cracking after the step of epitaxially growing. Consequently, the thicknesses of the silicon single crystal substrate 1' and the heteroepitaxial layer 3 can be made to an appropriate thickness that is necessary and sufficient to prevent the epitaxial substrate 5 from cracking.

The above is a description of the inventive method for producing a heteroepitaxial substrate.

According to the present invention, in this way, the thick substrate that exceeds the upper limit of the thickness standard as the silicon single crystal substrate 1' for heteroepitaxially growing, including diamond, is provided, and the heteroepitaxial layer 3 is grown, thereby suppressing warping and cracking. Moreover, after the growth of the heteroepitaxial layer 3, the silicon single crystal substrate 1' is thinned to the thickness standard set for each diameter, and this enables the substrate to be introduced into the existing device process.

Therefore, it is possible to perform the heteroepitaxial growth, including diamond, which is adapted to an existing silicon process while suppressing warping and cracking. Even when the thickness of the silicon single crystal substrate 1' is thickened beyond the standard to form the heteroepitaxial layer 3, it is possible to introduce the substrate into the existing device process.

### EXAMPLE

Hereinafter, the present invention will be specifically described with reference to Examples. However, the present invention is not limited thereto.

A thickness of the silicon single crystal substrate 1' was made thicker than a thickness standard and thinned after forming a heteroepitaxial layer 3, thereby producing an epitaxial substrate 5. Subsequently, the heteroepitaxial layer 3 was formed on the silicon single crystal substrate 1' that was within a thickness standard. Then, the presence or absence of cracking was compared between the above cases. Specific procedures were as follows.

First, as the step of producing a substrate, a high resistance boron-doped silicon single crystal substrate (resistivity 100 Ω•cm) having a diameter of 300 mm and plane orientation (111) on a surface thereof was provided as the silicon single crystal substrate 1'. The surface was then ground by a grindstone having a size of #8000 to roughen the silicon surface and introduce damage, which served as nuclei for diamond growth. At this time, high resistance silicon single crystal substrates of four types of thicknesses in total were provided as the silicon single crystal substrates 1', these included a substrate having a thickness of 0.775 mm, which was standard thickness according to SEMI Standards corresponding to a diameter of 300 mm (Comparative Example); substrates having a thickness of 1 mm, 1.5 mm, and 2 mm, which were thicker than the SEMI Standards (Examples).

Next, as the step of epitaxially growing, these substrates were placed in a hot filament CVD apparatus, and diamond was then epitaxially grown under conditions of a filament temperature of 2200°C, an H₂ flow rate of 10 SLM, a CH₄ concentration of 3%, a substrate temperature of 850°C, and a pressure in the apparatus of 5 Torr. (666.612 Pa) with the forming times set to 2, 4, and 8 hours in an attempt to produce epitaxial substrates 5. As a result, as shown in Table 3, as the growth time increased and the heteroepitaxial layer 3, composed of diamond, became thicker, some substrates were observed to have cracking after the step of epitaxially growing.

**[Table 3]**

| Thickness of Silicon Substrate (mm) | Diamond Growth Time (hrs.) | | |
|---|---|---|---|
| | 2 | 4 | 8 |
| 0.775 | Poor | Poor | Poor |
| 1.0 | Good | Poor | Poor |
| 1.5 | Good | Good | Poor |
| 2.0 | Good | Good | Good |

Finally, as the step of thinning, the silicon single crystal substrate 1' of the epitaxial substrate 5 that was not cracked in the step of epitaxially growing was thinned down to 0.775 ± 20 mm (775 ± 20 µm), which was within the SEMI Standards, by grinding; however, no crack was generated in the thinned epitaxial substrate 5.

According to the results above, it is found that even the silicon single crystal substrate 1', which is cracked when the heteroepitaxial layer 3 is formed within the thickness standard, can be made a thickness thicker than the thickness standard to have the heteroepitaxial layer 3 grown, and then thinning thereof within the thickness standard, thereby suppressing cracking and enabling the introduction into the existing device process.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a heteroepitaxial substrate, the method comprising the steps of:
producing a substrate in which a silicon single crystal substrate is produced under thickness conditions of a thickness of 2 mm or less, the thickness exceeds an upper limit of a thickness standard defined corresponding to a diameter of the silicon single crystal substrate;
epitaxially growing a heteroepitaxial layer on the silicon single crystal substrate obtained in the step of producing the substrate to obtain an epitaxial substrate; and
thinning the silicon single crystal substrate so as to fall within the thickness standard by grinding a surface of the silicon single crystal substrate opposite to a surface on which the heteroepitaxial layer is formed after the step of epitaxially growing.

2. The method for producing a heteroepitaxial substrate according to claim 1, wherein
the step of epitaxially growing is a step of growing the heteroepitaxial layer composed of any one of GaN, AlN, and diamond.

3. The method for producing a heteroepitaxial substrate according to claim 1 or 2, wherein
prior to the step of producing the substrate,
a relation between a thickness of the silicon single crystal substrate and a thickness of the heteroepitaxial layer is determined in advance, where the heteroepitaxial layer prevents the epitaxial substrate from cracking after the step of epitaxially growing; and based on the relation, the step of determining the thickness is performed to determine the thickness of the silicon single crystal substrate to be produced in the step of producing the substrate and the thickness of the heteroepitaxial layer to be grown in the step of epitaxially growing.
